Europäisches Patentamt

European Patent Office

Office européen des brevets

(19)

(11) **EP 0 753 755 A2**

(12) **EUROPÄISCHE PATENTANMELDUNG**

(43) Veröffentlichungstag:
**15.01.1997 Patentblatt 1997/03**

(51) Int. Cl.$^6$: **G01R 27/26**, A24C 5/18,
A24C 5/34

(21) Anmeldenummer: **96110434.6**

(22) Anmeldetag: **28.06.1996**

(84) Benannte Vertragsstaaten:
**AT BE CH DE ES FR GB IT LI NL SE**

(30) Priorität: **14.07.1995 DE 19525706**

(71) Anmelder: **Hauni Maschinenbau
Aktiengesellschaft
D-21033 Hamburg (DE)**

(72) Erfinder: **Möller, Henning, Dr.
22605 Hamburg (DE)**

(54) **Vorrichtung zur Messung der komplexen Dielektrizitätskonstanten von Tabak**

(57) Beschrieben wird eine Vorrichtung zur Messung der komplexen Dielektrizitätskonstanten von Tabak durch Auswertung der von der Anwesenheit des Tabaks (12) verursachten Verstimmung einer HF-Resonatoranordnung mit zwei jeweils ein Gehäuse (2,3) aufweisenden HF-Resonatoren, von denen mindestens einer eine Verstelleinrichtung für die Resonanzfrequenz aufweist, und mit einer Steuer- und Auswerteeinheit, mit der eine HF-Sendeeinrichtung (31) und/oder die HF-Resonatoren so steuerbar sind, daß die beiden HF-Resonatoren mit HF-Feldern der gleichen Frequenz (W) gespeist werden, welche in Abwesenheit des Tabaks in der Mitte zwischen den unterschiedlich voreingestellten Resonanzfrequenzen ($W_{10}$,$W_{20}$) des ersten und des zweiten HF-Resonators liegt, und die bei Anwesenheit des Tabaks die gemessenen Amplitudenwerte ($F_1$,$F_2$) der jeweils in den beiden HF-Resonatoren empfangenen HF-Signale ($f_1$,$f_2$) aufnimmt und auf Grundlage von deren Summen- und Differenzwerten die komplexe Dielektrizitätskonstante ($\varepsilon$) des Tabaks bestimmt.

Die Erfindung besteht darin, daß die Gehäuse (2,3) jeweils eine Einlaßöffnung (7,8) sowie Auslaßöffnung (9,11) zum Durchleiten eines Stranges der tabakverarbeitenden Industrie, insbesondere eines Zigarettenstranges (12), aufweisen.

Fig. 5

**Beschreibung**

Die Erfindung betrifft eine Vorrichtung zur Messung der komplexen Dielektrizitätskonstanten von Tabak durch Auswertung der von der Anwesenheit des Tabaks verursachten Verstimmung einer HF-Resonatoranordnung mit zwei jeweils ein Gehäuse aufweisenden HF-Resonatoren, von denen mindestens einer eine Verstelleinrichtung für die Resonanzfrequenz aufweist, und mit einer Steuer- und Auswerteeinheit, mit der eine HF-Sendeeinrichtung und/oder die HF-Resonatoren so steuerbar sind, daß die beiden HF-Resonatoren mit HF-Feldern der gleichen Frequenz gespeist werden, welche in Abwesenheit des Tabaks in der Mitte zwischen den unterschiedlich voreingestellten Resonanzfrequenzen des ersten und des zweiten HF-Resonators liegt, und die bei Anwesentheit des Tabaks die gemessenen Amplitudenwerte der jeweils in den beiden HF-Resonatoren empfangenen HF-Signale aufnimmt und auf Grundlage von deren Summen- und Differenzwerten die komplexe Dielektrizitätskonstante des Tabaks bestimmt.

Durch die DE-PS 43 42 505 ist eine Meßvorrichtung der obenbezeichneten Art beschrieben, bei der die Gehäuse mit einem ersten Abschnitt, welcher den Festkörperresonator wenigstens in einer Hemisphäre mit leitfähigem Material umschließt, und mit einem zweiten Abschnitt, der für elektromagnetische Wechselfelder durchlässig ist, versehen sind. Die beiden HF-Resonatoren sind so zueinander positionierbar, daß ihre leitfähigen Gehäuseabschnitte sie gegen wechselseitige Beeinflussung abschirmen und ihre für elektromagnetische Felder durchlässigen Abschnitte dem zu messenden Stoff zugewandt sind. Dies bedeutet, daß nur Streufelder nach außen treten und in die Probe, z. B. den Tabak, eindringen können, was aber die Empfindlichkeit und Genauigkeit bei kleinen und schnell bewegten Proben wie einem Strang der tabakverarbeitenden Industrie, z. B. einem Zigarettenstrang, beeinträchtigt. Ein derartiger Zigarettenstrang, von dem fortlaufend Zigaretten einfacher oder doppelter Gebrauchslänge abgeschnitten werden, besteht aus einem mit verklebtem Zigarettenpapier umgebenen Strang aus Tabakfasern. Der Mengenstrom des Tabaks (Tabakmasse-/Längeneinheit) in dem Zigarettenstrang soll, zumindest über größere Abschnitte, möglichst konstant sein. Um die Füllung des Zigarettenstranges mit Tabak steuern zu können, muß zunächst der Mengenstrom erfaßt werden. Hierzu wird heute Strahlung (z. B. von Beta-Strahlern oder Infrarotstrahlern) benutzt, deren Schwächung ein Maß für die Tabakmasse im Meßbereich ist. Auch eine Messung des Tabakmengenstromes mittels Hochfrequenz ist bekannt. Mit mengenstromabhängigen Meßsignalen kann dann die Bildung des Tabakstranges vor dem Umhüllen mit einem Zigarettenpapierstreifen so gesteuert werden, daß der Mengenstrom zumindest annähernd konstant ist. Hierzu wird von den mengenstromabhängigen Meßsignalen ein sogenannter Trimmer oder Egalisator so gesteuert, daß er mehr oder weniger Tabak von dem bewegten Tabakstrang im Sinne einer Konstanthaltung des Mengenstromes abnimmt. Eine entsprechende Vorrichtung zeigt z. B. die US-PS 4 875 494.

Die der Erfindung zugrundeliegende Aufgabe besteht in einer Weiterbildung der Meßanordnung gemäß der DE-PS 43 42 505. Die Lösung gemäß der Erfindung besteht darin, daß die Gehäuse jeweils eine Einlaßöffnung sowie eine Auslaßöffnung zum Durchleiten eines Stranges der tabakverarbeitenden Industrie, insbesondere eines Zigarettenstranges, aufweisen. Andere Stränge der tabakverarbeitenden Industrie können anderes Rauchmaterial für Zigaretten, z. B. synthetisches Rauchmaterial, Filtermaterial oder Zigarillo- oder Zigarrentabak enthalten.

Der Vorteil der Vorrichtung gemäß der Erfindung besteht in einer größeren Empfindlichkeit und Genauigkeit.

Weiterbildungen und weitere Ausgestaltungen der Erfindung sind den untergeordneten Ansprüchen zu entnehmen.

Die Erfindung wird anhand von Ausführungsbeispielen näher beschrieben.

Es zeigen:

Figur 1    einen Schnitt durch eine zwei Gehäuse aufweisende mit Mikrowellen beaufschlagbare HF-Resonatoranordnung gemäß der Erfindung,

Figur 2    eine Ansicht der Resonatoranordnung der Figur 1 gemäß Pfeil A,

Figur 3    den Verlauf von Resonanzkurven für zwei Gehäuse mit und ohne Materialfüllung,

Figur 4    eine Schemaskizze für eine Auswertschaltung zur Ermittlung des Real- u. Imaginärteiles der Dielektrizitätskonstanten des die Gehäuse durchsetzenden Materials,

Figur 5    einen Schnitt durch eine zwei Gehäuse mit jeweils einem dielektrischen Festkörperresonator aufweisende HF-Resonatoranordnung.

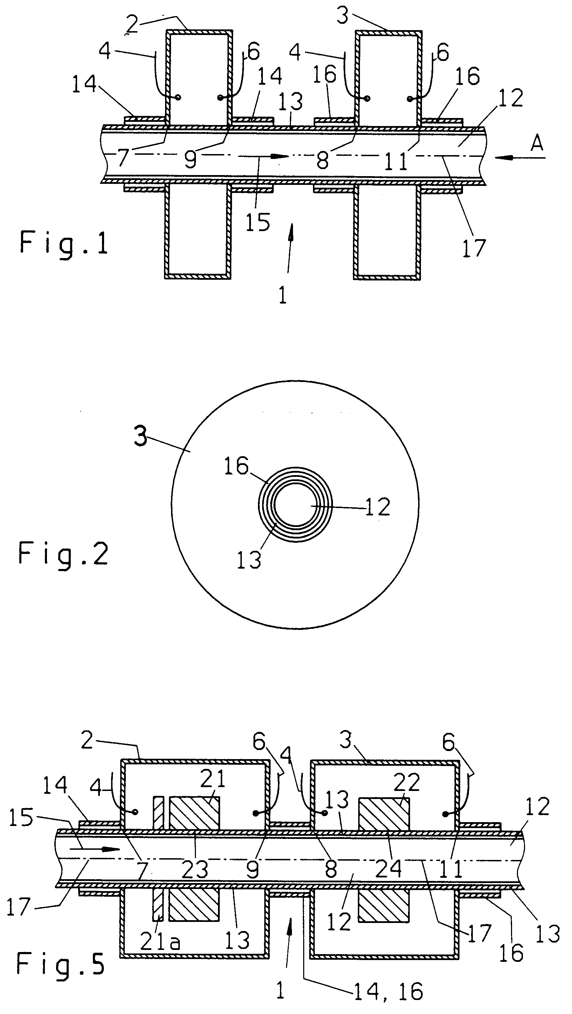

Die Figuren 1 und 2 zeigen eine Hochfrequenz(HF)-Resonatoranordnung 1 gemäß der Erfindung, die zwei Resonatoren in Form von zwei Gehäusen 2 und 3 aufweist. Die Gehäuse sind rotationssymmetrisch, in dem Beispiel zylinderförmig, ausgebildet und bestehen aus elektrisch leitenden Material wie Kupfer. Sie können aber auch andere rotationssymmetrische Formen oder davon abweichende Formen, z. B. die Form von Polygonen, aufweisen. Zur Einkopplung eines elektromagnetischen Hochfrequenz(HF)-Feldes (Mikrowellen) und zur Auskopplung des HF-Feldes dienen Koaxialkabel 4 bzw. 6, die nicht dargestellte aber vorbekannte Koppelschleifen aufweisen. Die Gehäuse 2 und 3 können nicht dargestellte Einrichtungen zum Einstellen und Verstellen der Resonanzfrequenzen enthalten, die im einfachsten Fall als Metallschrauben ausgebildet sind. Das in der HF-Resonatoranordnung 1 realisierte Meßverfahren zur Ermittlung der komplexen Dielektrizitätskonstanten ist ausführlich in der DE-PS 43 42 505 beschrieben, auf die ausdrücklich Bezug genommen wird. Das Verfahren führt zu folgenden Endgleichungen für die komplexe Dielektrizitätskonstante $\Delta\varepsilon$ :

$$\Delta\varepsilon' \text{ prop } \frac{F1 - F2}{F10 + F20}$$

als Realteil der komplexen Dielektrizitätskonstanten $\varepsilon$, wobei das Delta für die Differenz zwischen den mit Meßgut durchsetzten Gehäusen 2 und 3 und den leeren Gehäusen steht,

$$\Delta\varepsilon'' \text{ prop } \frac{F10 + F20 - (F1 + F2)}{F10 + F20}$$

als Imaginärteil der komplexen Dielektrizitätskonstanten, wobei das Delta ( $\Delta$ )wieder für die gleiche Differenz steht.

Da die Luft, die leere Gehäuse füllt, eine Dielektrizitätskonstante von ca. 1 hat, sind die $\Delta\varepsilon'$ und $\Delta\varepsilon''$ mit guter Genauigkeit ein Maß für $\varepsilon'$ bzw. $\varepsilon''$.

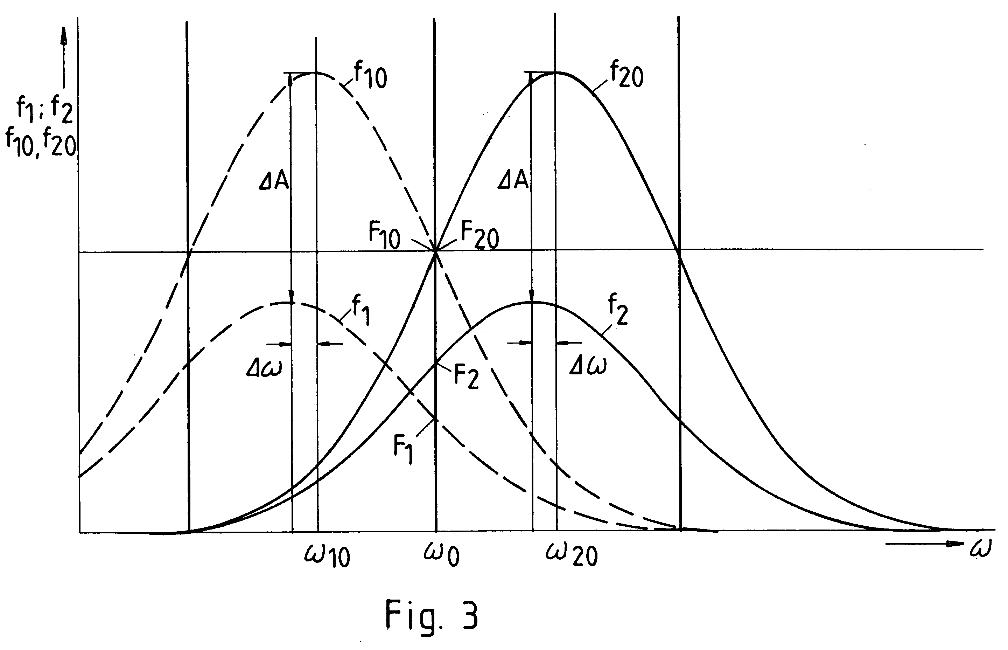

Die Ermittlung der Größen F1, F2, F10, F20 läßt sich gemäß Figur 3 anhand der Resonanzkurven f10, f20 bei leeren Gehäusen 2 bzw. 3 sowie f1, f2 bei mit Material gefüllten oder durchsetzten Gehäusen zeigen. Die Resonanzkurven werden so gebildet, daß die Resonanzfrequenzen $\omega$10 und $\omega$20 in den Gehäusen 2 und 3 geringfügig unterhalb bzw. oberhalb einer Betriebsfrequenz $\omega$ von Mikrowellen, mit denen beide Gehäuse beaufschlagt werden, eingestellt werden. Bei mit Material gefüllten Gehäusen verschieben sich die Resonanzfrequenzen beider Resonanzkurven um einen Betrag $\Delta\omega$ zu niedrigeren Frequenzen hin. Außerdem sinken die Amplituden der Resonanzfrequenzen infolge der Dämpfungen der Mikrowellen durch das Material um einen Betrag $\Delta$ A.Die Werte F10 und F20 bei leeren Gehäusen (z. B. Spannungen der gleichgerichteten Mikrowellen, die an den Koaxialkabeln 6 abgenommen werden) sind bei der gemeinsamen Betriebsfrequenz $\omega$ und gleicher Ausbildung der Gehäuse gleich groß. Der Wert F1 wird erfaßt z. B. als Spannung der gleichgerichteten Mikrowellen an dem Koaxialkabel 6 des mit Material gefüllten Gehäuses 2. Der Wert F2 wird erfaßt z. B. als Spannung der gleichgerichteten Mikrowellen an dem Koaxialkabel 6 des mit Material gefüllten Gehäuses 3.

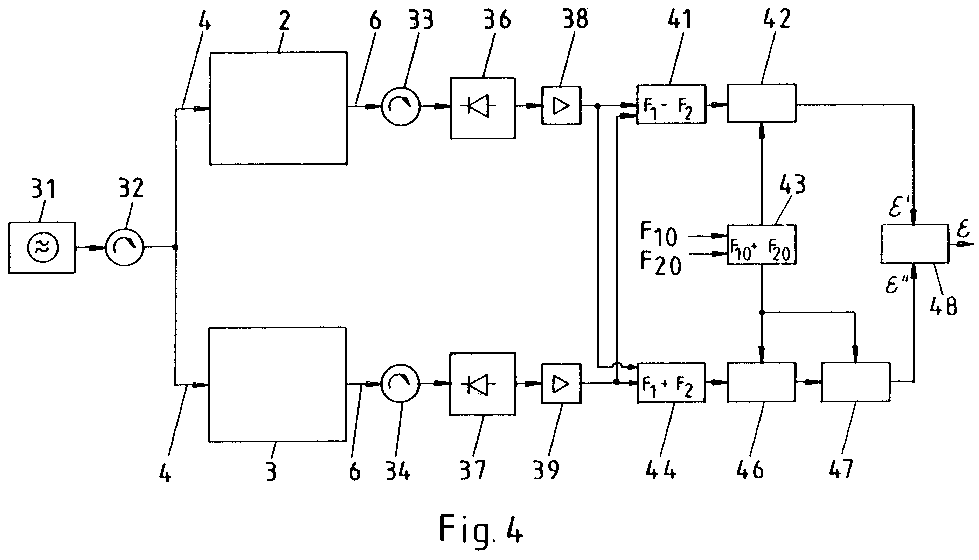

Die Ermittlung der Werte $\varepsilon'$ und $\varepsilon''$, die bei komplexer Addition den Wert $\varepsilon$ ergeben, wird anhand der Schaltungsanordnung in Figur 4 beschrieben.

Ein Mikrowellengenerator 31 gibt über einen bekannten Zirkulator 32 zur Verhinderung einer Rückkopplung Mikrowellen hoher Frequenzen (vorzugsweise im Gigahertzbereich, z. B. bei ca. 6 Gigahertz) an die Koaxialkabel 4 der Gehäuse 2 und 3. Die von dem Material in den Gehäusen beeinflußten Ausgangssignale werden über Zirkulatoren 33, 34 Mikrowellendioden 36 bzw. 37 zugeführt, die beispielsweise vom Typ HP 847 2B der Fa. Hewlett-Packard, 71034 Böblingen, DE, sein können und die hochfrequenten Mikrowellen in Gleichspannungssignale entsprechend F1 bzw. F2 umsetzen. Das von einem Verstärker 38 verstärkte Gleichspanungssignal von Gehäuse 2 ebenso wie das von einem Verstärker 39 verstärkte Gleichspannungssignal des Gehäuses 3 wird einer Differenzschaltung 41 zum Bilden der Differenz von F1 und F2 zugeführt. Das Ausgangssignal von 41 gelangt zu einem Divisionsglied 42, dem außerdem noch ein Ausgangssignal von einem Summierglied 43 zugeführt ist. Das Ausgangssignal von 43 entspricht der Summe aus den konstanten Signalen F10 und F20. Das im Divisionsglied 42 durch Division des Differenzensignals von 41 und des Summensignals von 43 gebildete Signal entspricht dem Realteil $\varepsilon'$ der komplexen Dielektrizitätskonstanten $\varepsilon$ des untersuchten Materials.

Aus den Ausgangssignalen von Verstärker 38 und 39 wird in einem Summierglied 44 ein Summensignal gebildet, das einem Subtraktionsglied 46 zugeführt wird. Dort wird es von einem von Summierglied 43 abgegebenen Signal abgezogen. Das Ausgangssignal von 43 wird einem Divisionsglied 47 zugeführt, in dem der Quotient der Ausgangssignale von 46 und 43 gebildet wird.

Das Ausgangssignal von 47 entspricht dem Imaginärteil $\varepsilon''$ der komplexen Dielektrizitätskonstanten $\varepsilon$ , die ihrerseits in einem komplexen Summierglied 48 aus $\varepsilon'$ und $\varepsilon''$ gebildet werden kann. Aus elektrischen Signalen, die diesen Beziehungen entsprechen, kann auf Masse und/oder Feuchtewerte des Tabaks in einem Zigarettenstrang, der die Gehäuse durchsetzt, geschlossen werden.

Hierzu weisen die Gehäuse 2 und 3 jeweils eine Einlaßöffnung 7 bzw. 8 sowie eine Auslaßöffnung 9 bzw. 11 auf. Der Zigarettenstrang 12 wird in einer rohrförmigen Führung 13 aus elektrisch nichtleitendem Material, z. B. Quarz, entsprechend dem Pfeil 15 durch die Gehäuse geführt. Es wird somit vermieden, daß Tabakteilchen, Staub oder dgl. in die Gehäuse 2 und 3 gelangen und dabei Störungen verursachen.

Rohrförmige Stutzen 14, 16 aus leitfähigem Material wie Metall verhindern ein Abstrahlen des HF-Feldes in störendem Ausmaß durch die Ein- und Auslaßöffnungen der Gehäuse 2 und 3.

Durch die besondere konzentrische Anordnung der Führung 13 und damit des Zigarettenstranges 12 bezüglich der Gehäuseachse 17 ergibt sich ein symmetrischer Aufbau mit optimalen Meßeigenschaften.

Die Vorrichtung gemäß Figur 5 unterscheidet sich von derjenigen gemäß den Figuren 1 und 2 dadurch, daß die Gehäuse 2 und 3 jetzt noch zusätzliche zylindrische dielektrische Resonatoren 21 bzw. 22, z. B. aus einem geeigneten Keramikmaterial, enthalten, die in ihren Lagen durch nicht dargestellte Abstandshalter fixiert sein können. Die Führung 13 und damit der Zigarettenstrang 12 können durch Durchlässe 23 und 24 hindurch die Resonatoren 21 bzw. 22 durchsetzen. Der Resonator 21 hat einen Teil 21a, der relativ zu ihm verschiebbar ist, z. B. um die Resonanzfrequenz ermitteln zu können. Auch der Resonator 22 kann einen entsprechenden relativ verschiebbaren Teil aufweisen.

Durch die dielektrischen Resonatoren 21 und 22 kann die Empfindlichkeit und Genauigkeit der Messung noch heraufgesetzt werden.

**Patentansprüche**

1. Vorrichtung zur Messung der komplexen Dielektrizitätskonstanten von Tabak durch Auswertung der von der Anwesenheit des Tabaks verursachten Verstimmung einer HF-Resonatoranordnung mit zwei jeweils ein Gehäuse aufweisenden HF-Resonatoren, von denen mindestens einer eine Verstelleinrichtung für die Resonanzfrequenz aufweist, und mit einer Steuer- und Auswerteeinheit, mit der eine HF-Sendeeinrichtung und/oder die HF-Resonatoren so steuerbar sind, daß die beiden HF-Resonatoren mit HF-Feldern der gleichen Frequenz gespeist werden, welche in Abwesenheit des Tabaks in der Mitte zwischen den unterschiedlich voreingestellten Resonanzfrequenzen des ersten und des zweiten HF-Resonators liegt, und die bei Anwesenheit des Tabaks die gemessenen Amplitudenwerte der jweils in den beiden HF-Resonatoren empfangenen HF-Signale aufnimmt und auf Grundlage von deren Summen- und Differenzwerten die komplexe Dielektrizitätskonstante des Tabaks bestimmt, dadurch gekennzeichnet, daß die Gehäuse (2, 3) jeweils eine Einlaßöffnung (7, 8) sowie eine Auslaßöffnung (9, 11) zum Durchleiten eines Stranges der tabakverarbeitenden Industrie, insbesondere eines Zigarettenstranges (12) aufweisen.

2. Vorrichtung nach Anspruch 1, dadurch gekennzeichnet, daß die Resonatoren jeweils ein vorzugsweise symmetrisches Gehäuse (2, 3) aufweisen, in die Leitungen (4) für ein elektrisches HF-Feld führen und aus denen Leitungen (6) zur Abnahme des Meßsignals herausführen.

3. Vorrichtung nach Anspruch 1 und/oder 2, dadurch gekennzeichnet, daß die Gehäuse rotationssymmetrisch, vorzugsweise zylindrisch, ausgebildet sind und daß die Ein- und Auslaßöffnungen koaxial zu den Achsen (17) der Gehäuse (2, 3) angeordnet sind.

4. Vorrichtung nach einem oder mehreren der vorhergehenden Ansprüche, dadurch gekennzeichnet, daß in den Gehäusen dielektrische Festkörperresonatoren (21, 22) angeordnet sind.

5. Vorrichtung nach Anspruch 4, dadurch gekennzeichnet, daß die Festkörperresonatoren (21, 22) mit Durchlässen (23, 24) für den Zigarettenstrang (12) versehen sind.

6. Vorrichtung nach einem oder mehreren der vorhergehenden Ansprüche, dadurch gekennzeichnet, daß eine die Gehäuse (2, 3) und ggf. die Festkörperresonatoren (21, 22) durchsetzende geschlossene rohrartige Führung (13) für den Zigarettenstrang (12) vorgesehen ist.

7. Vorrichtung nach einem oder mehreren der vorhergehenden Ansprüche, dadurch gekennzeichnet, daß rohrförmige Stutzen (14, 16) aus leitfähigem Material, insbesondere Metall, die Rohrführung (13) an den Ein- und Auslässen (7 ... 11) der Gehäuse (2, 3) umgeben.

Fig.1

Fig.2

Fig.5

Fig. 3

Fig. 4